# EUROPEAN PATENT APPLICATION

(11) **EP 4 219 059 A1**
(43) Date of publication of application: **02.08.2023**
(21) Application number: 21886106.0
(22) Date of filing: 25.10.2021
(51) Int. Cl.: B23K 20/00, C22C 5/06, H01L 21/52, B22F 3/24

(54) **BONDING STRUCTURE AND SEMICONDUCTOR DEVICE HAVING SAID BONDING STRUCTURE**

(30) Priority: 29.10.2020 JP 2020181568
(71) Applicant: Tanaka Kikinzoku Kogyo K.K., Tokyo 100-6422 (JP)
(72) Inventor: KISHIMOTO, Takaomi, Tomioka-shi, Gunma 370-2452 (JP); TAKEUCHI, Junichi, Oshu-shi, Iwate 023-1101 (JP); TORINOUMI, Hiraku, Oshu-shi, Iwate 023-1101 (JP)
(74) Representative: Hoffmann Eitle
(86) International application number: PCT/JP2021/039202
(87) International publication number: WO 2022/091988

(57) **Abstract**

The invention relates to, for example, a bonding structure to be formed in bonding of a Si semiconductor or the like and a substrate, as materials to be bonded, with transient liquid phase diffusion bonding. The bonding structure includes a bonding portion presenting a specific material texture. A metal composition of the bonding portion includes 78.0% by mass or more and 80.0% by mass or less of Ag, 20.0% by mass or more and 22.0% by mass or less of Sn, and an inevitable impurity element. A characteristic material texture configured from an island-like Ag phase including 95% by mass or more of Ag and a AgsSn phase including a AgsSn intermetallic compound and surrounding the island-like Ag phase is presented in observation of any cross section of the bonding portion. The bonding portion in the inventive bonding structure is suitable in bonding strength and excellent in heat resistance and durability due to the material texture.

## Description

### BACKGROUND OF THE INVENTION

### FIELD OF THE INVENTION

The present invention relates to a bonding structure for bonding a semiconductor element such as a Si semiconductor and a substrate. Particularly, the invention relates to a bonding structure which is lead-free and which is high in bonding strength and also excellent in durability to thermal stress, and heat resistance.

### DESCRIPTION OF THE RELATED ART

Semiconductor devices such as a power device for use in hybrid cars, EVs, power-generating facilities, and the like are constructed by bonding of a semiconductor element to a circuit substrate provided with a radiator plate including copper or the like. In a semiconductor device having such a structure, a bonding portion between the semiconductor element and the circuit substrate is demanded to have high reliability. Such a bonding portion is required to have many properties in order to ensure its reliability. Specifically, high durability is required which not only allows high bonding strength between the semiconductor element and the circuit substrate to be exhibited, but also causes no cracks even with repeated thermal stress due to the difference in thermal expansion. Moreover, high heat resistance is also demanded which causes neither melting nor softening even with heat generated in a manufacturing step or an operation process of a semiconductor device.

In recent years, a semiconductor element in the semiconductor device has been progressively improved for an enhancement in energy efficiency and an increase in power density. Such improvements cause temperature rise of the bonding portion, and there is a need for a bonding portion capable of having various properties described above even under the temperature rise situation.

A constituent material of a bonding portion in a semiconductor device tends to be increasingly demanded to be Pb-free. The above-mentioned bonding portion of the semiconductor device, which generates heat, is formed by use of, for example, a high-melting point solder high in Pb content, such as Pb-10% by mass of Sn or Pb-5% by mass of Ag. Such a high-melting point solder has a melting point (liquidus-line temperature) of 300°C or more, and allows for formation of a bonding portion also capable of withstanding an increase in temperature of such a bonding portion due to, for example, an increase in power density. However, use of Pb has been liable to be avoided in consideration of recent regulation from environmental issues, and a bonding portion in a semiconductor device has also been increasingly demanded to be Pb-free.

Thus, a bonding portion which not only is Pb-free, but also can have bonding strength, durability and the like has been progressively developed, and one development thereof corresponds to formation of a bonding portion according to a transient liquid phase diffusion bonding (TLP) method. The transient liquid phase diffusion bonding method is a bonding method including placing a bonding material (insert metal) as a combination of predetermined two or more metals different in melting point, between materials to be bonded, and partially melting such an insert metal and the materials to be bonded, with heating to a temperature around a lower melting point of such an insert metal, to result in diffusion bonding.

Examples of the transient liquid phase diffusion bonding include a method employing, as an insert metal, a combination of Sn as a low-melting point metal and Ag as a high-melting point metal. Such transient liquid phase diffusion bonding where Sn and Ag serve as an insert metal results in melting of Sn with heating to a temperature (200 to 250°C) around the melting point of Sn, as a bonding temperature. When this state is kept with such a heating temperature being constant, Sn, which is formed into a liquid phase, diffuses to the interface thereof with the materials to be bonded, for integration, and also diffuses to Ag to form an intermetallic compound (Ag₃Sn) together with Ag. The intermetallic compound has a high melting point of about 480°C, and can increase the melting point of a bonding portion. Thus, such transient liquid phase diffusion bonding is characterized in that configuration of an insert metal can be appropriately set to thereby not only allow for a low bonding temperature, but also enable a bonding portion having a high melting point to be formed. In a conventional bonding method with a general bonding material such as a solder or a brazing filler metal, the bonding temperature in bonding and the melting point of a bonding portion to be formed have been almost the same as each other. On the contrary, such transient liquid phase diffusion bonding allows for formation of a bonding portion having a higher melting point than the bonding temperature. Thus, an intermetallic compound having a high melting point can be included to thereby provide a bonding portion high in heat resistance.

An application example of such transient liquid phase diffusion bonding to a semiconductor device is, for example, a bonding structure described in Patent Document 1. In the prior art, a bonding portion (bonding material layer) has been formed with transient liquid phase diffusion bonding using a solder material including a low-melting point metal mainly of Sn and high-melting point metals of Ni, Cu, and Ag. A bonding structure of the bonding portion presents a material texture where a spherical, columnar, or elliptically shaped intermetallic compound ((Cu,Ni)₆Sn₅, Ag₃Sn) is dispersed in a stress release object containing Sn as a main component. The prior art has allowed the stress release object packed in such a metal compound to inhibit the occurrence or progression of cleavage, thereby enabling durability of the bonding portion to be ensured.

### Prior Art Document

### Patent Document

Patent Document 1 Japanese Patent Application Laid-Open No. 2018-98265

### SUMMARY OF THE INVENTION

### TECHNICAL PROBLEM

It is deemed that the above prior art can impart various properties demanded for a bonding portion, because a characteristic intermetallic compound is formed with transient liquid phase diffusion bonding and also durability due to a stress release object of Sn is counted. However, a bonding portion formed in the prior art includes Sn being a low-melting point metal, as a main component, and is thus considered to be insufficient in heat resistance. In other words, such a bonding portion of the prior art, while includes an intermetallic compound formed of Sn, includes most of Sn remaining as the stress release object. Accordingly, the bonding portion, while has a high melting point in a region where the intermetallic compound of Sn is present, has a low melting point in a region where Sn remains, and is hardly deemed to be high in heat resistance in whole. Therefore, the bonding portion has concerns about softening and partial melting under a high temperature. The softening and the like under a high temperature may lead to deterioration in strength of a bonding layer itself, and the bonding layer itself may be broken. The conventional transient liquid phase diffusion bonding is thus expected to be difficult to apply to semiconductor devices which are likely to have increased power density also in the future.

The present invention has been made in view of the above circumstances, and provides a Pb-free bonding structure obtained with transient liquid phase diffusion bonding, in which not only bonding strength is ensured, but also heat resistance as a target of transient liquid phase diffusion bonding can be exhibited and durability is also excellent.

### SOLUTION TO PROBLEM

In the technical background described with respect to the present invention, a challenge has been how to form a bonding portion as an alternative to a high-Pb solder excellent in heat resistance, such as Pb-10% by mass of Sn or Pb-5% by mass of Ag. It is necessary for this to change a main component of a bonding portion from Pb to other metal. Patent Document 1 above discloses, as such a change in main component of a bonding portion, a change in main component of a bonding portion to Sn by means of the action of transient liquid phase diffusion bonding. While it is effective for bonding portion formation to adopt Sn being a low-melting point metal, as a main component, a bonding portion insufficient in heat resistance is obtained as described above.

The present inventors have progressively studied a bonding portion formed with transient liquid phase diffusion bonding, different from direction of the conventional art, in which Ag is applied as a main component as an alternative to Pb and the bonding portion appropriately includes Sn capable of forming an intermetallic compound with Ag. The reason is because Ag is a relatively soft metal and has a high melting point and thus can be expected to be capable of forming a suitable bonding portion. Of course, use of Ag as a main component is here expected to hardly allow objective properties to be exhibited depending on the existence form of Ag after bonding portion formation.

The inventors have then reviewed a method for forming a bonding portion and have decided to study a procedure which enables transient liquid phase diffusion bonding to effectively progress. As a result, it has been found that a bonding portion formed with adopting of a compression-molded article including a Ag powder and a Sn powder described below, as a bonding material (insert metal) for transient liquid phase diffusion bonding, and by use of the bonding material under appropriate conditions exhibits effective heat resistance and bonding strength, and durability. The inventors have studied a structure of the bonding portion here formed, and thus have conceived the invention relating to a bonding portion having a characteristic material texture.

In other words, the invention provides a bonding structure including a pair of materials to be bonded, and a bonding portion formed between the pair of materials to be bonded, wherein the bonding portion includes, as constituent elements, 78.0% by mass or more and 80.0% by mass or less of Ag, 20.0% by mass or more and 22.0% by mass or less of Sn, and an inevitable impurity element, and a material texture configured from an island-like Ag phase including 95% by mass or more of Ag and a AgsSn phase including a AgsSn intermetallic compound and surrounding the island-like Ag phase is observed in observation of any cross section of the bonding portion. Hereinafter, a configuration and a formation method of the bonding structure of the invention are described.

### A. Configuration of bonding structure of the present invention

As described above, the bonding structure of the invention includes a pair of materials to be bonded, and a bonding portion formed therebetween, as essential components. The bonding portion formed between the pair of materials to be bonded means a bonding portion sandwiched between the pair of materials to be bonded, in a contact or non-contact manner. The phrase "sandwiched between the pair of materials to be bonded, in a non-contact manner" means that a diffusion layer different in composition/structure from the bonding portion and the materials to be bonded is present on an interface between the bonding portion and the materials to be bonded and the bonding portion and the materials to be bonded are not in direct contact with each other. As described below, such a diffusion layer may be generated on a bonding interface depending on production conditions of the bonding portion (composition of the bonding material) in the invention. The diffusion layer is optional constituent component, and is thus defined as described above. Hereinafter, each constituent component (materials to be bonded, bonding portion, and optional diffusion layer) of the bonding structure of the invention is described in detail.

### A-1. Member to be bonded

The type, application, structures/dimension, and the like of the materials to be bonded, in the bonding structure of the invention, are not particularly limited. A representative application of the invention is a bonding structure of a semiconductor element (Si or the like) and a circuit substrate, and in this case, such element and substrate serve as the pair of materials to be bonded. Herein, the constituent material, the structure/dimension, and the like of the semiconductor element are not limited. In a general semiconductor device, a circuit substrate is provided with a Cu plate or the like placed on a ceramic substrate, for diffusion of heat from a semiconductor element, and the material of the substrate and the presence of the Cu plate are not limited.

### A-2. Bonding portion

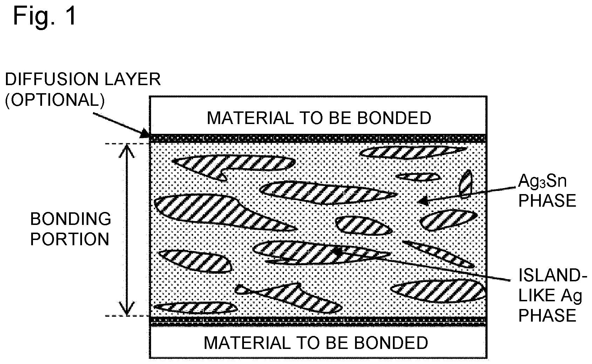

A bonding portion is a main essential constituent component in the bonding structure of the invention. A bonding portion in the bonding structure of the invention includes Ag being a constituent element, as a main component. Ag partially serves a AgsSn intermetallic compound and excess Ag not forming any intermetallic compound is dispersed as an island-like metal phase. As a result, the bonding portion of the invention presents a material texture including an island-like Ag phase and a AgsSn phase which is packed in a void in the island-like Ag phase and which surrounds the island-like Ag phase. Fig. 1 illustrates a cross section of the bonding portion in the bonding structure of the invention in order to easily understand an aspect of the material texture.

Ag is a metal having a higher melting point than Sn and the like, and thus the bonding portion can be configured from a Ag phase and a AgsSn phase and therefore the bonding portion can entirely have a high-melting point and ensure heat resistance. Ag is also a metal having a high heat conductivity, and thus can also be expected to be dispersed in an island-like manner to thereby allow the entire bonding portion to be favorable in heat conducting properties. Furthermore, Ag is a relatively soft metal, and has more softness than an intermetallic compound which is likely high in hardness and brittle. It is considered that the island-like Ag phase in the bonding portion in the bonding structure of the invention serves as a buffering material when the bonding portion receives thermal stress. Thus, it is considered that the bonding structure of the invention is also favorable in durability and the occurrence of cracks due to stress loading can also be suppressed. As described above, the bonding structure of the invention can exhibit a characteristic material texture and thus can exhibit suitable properties in a bonding portion of a semiconductor device.

### A-2-1. Composition of bonding portion

The entire composition of the bonding structure of the present invention is constituted from 78.0% by mass or more and 80.0% by mass or less of Ag, 20.0% by mass or more and 22.0% by mass or less of Sn, and inevitable impurity element. The reason why Ag is adopted as a main component is because, as described above, advantageous properties of Ag, for example, high melting point and high heat conduction are counted. Ag can form AgsSn being an intermetallic compound together with Sn, and thus can be applied to transient liquid phase diffusion bonding.

The Ag content in the bonding portion of the invention is 78.0% by mass or more and 80.0% by mass or less. According to studies by the inventors, a bonding portion based on transient liquid phase diffusion bonding, made by the inventors, described below, exhibits suitable bonding strength when the content range of Ag is narrow as described above. If the Ag content in the bonding portion is less than 78.0% by mass or more than 80.0% by mass, at least any bonding strength at room temperature or a high temperature is insufficient and durability is also inferior. Such a narrow composition range in the bonding portion, together with the material texture, is characteristic of the bonding structure of the invention.

Herein, the Ag content means the entire Ag content in the bonding portion, and corresponds to the sum of the Ag content in the Ag phase and the Ag content in the AgsSn phase. While an optional diffusion layer can be provided on an interface between the materials to be bonded and the bonding portion in the bonding structure of the invention, as described above, the entire composition means the entire composition of the total content of Ag and Sn in only the bonding portion except the diffusion layer.

The bonding portion essentially includes not only Ag, but also Sn in the constituent element thereof, and is in principle constituted only from such elements. Herein, any inevitable impurity element is allowed to be included. As such inevitable impurities, Cu, Pb, and the like can be included. The inevitable impurities is preferably 0.1% by mass or less in total relative to the entire bonding portion.

### A-2-2. Material texture of bonding portion

### (1) Island-like Ag phase

The Ag phase is a metal phase having a Ag concentration of 95% by mass or more. The Ag phase may be of pure Ag (have a Ag concentration of 100% by mass), and here has a Ag content of 95% by mass or more because of being also probably affected by Sn and/or inevitable impurities in the course of formation of the bonding structure. The Ag phase is distributed as an island-like form in a material texture in a cross section of the bonding portion, in the bonding structure. Such an island-like Ag phase is a Ag phase distributed having an individually independent shape, and is a metal phase which is not in the state of being linked or connected in a columnar or laminar manner in a cross-section texture. It is considered in the present invention that enhancements in heat resistance and durability are achieved by distribution of such a Ag phase having an individually independent shape in a cross-section texture. Such a Ag phase, if present in a columnar or laminar manner, may cause properties of the bonding portion to be anisotropic. The shape of the island-like Ag phase is not particularly defined, and is, for example, spherical, elliptically shaped, or indefinitely shaped.

### (2) AgsSn phase

The AgsSn phase is one including AgsSn being an intermetallic compound of Ag and Sn, and surrounding the island-like Ag phase in a material texture in a cross section of the bonding portion. The AgsSn phase is a main phase which together with the island-like Ag phase configures the bonding portion. AgsSn has a melting point of about 480°C and thus contributes to heat resistance of the bonding portion. AgsSn is an intermetallic compound and is also excellent in strength, and thus can also contribute to bonding strength. The thermal stress which the AgsSn phase receives is absorbed with the Ag phase which is relatively soft, and it is also expected that the entire bonding portion ensures durability against the thermal stress. Such an enhancement in durability is included in properties hardly expected in a bonding portion configured from a AgsSn phase singly or one mostly configured from a AgsSn phase. The composition of a AgsSn intermetallic compound exhibits 73% by mass of Ag-27% by mass of Sn due to the atomic ratio (Ag:Sn = 3:1), and is approximate to the composition of the AgsSn phase in the invention.

### (3) Area percentage of island-like Ag phase in bonding portion

A characteristic material texture in the present invention is observed in any cross section of the bonding portion. The area percentage of the island-like Ag phase in the material texture in the invention is preferably 18% or more. It is presumed that the proportion of the Ag phase can contribute to bonding strength and durability of the bonding portion. A low area percentage of the Ag phase leads to insufficient bonding strength at a high temperature, and thus the lower limit value of the area percentage of the island-like Ag phase is preferably 18% or more. The lower limit value of the area percentage of the island-like Ag phase is more preferably 10% or more, further preferably 15% or more, particularly preferably 25% or more. A too high proportion of the island-like Ag phase leads to instable bonding itself, thereby making it difficult to obtain required bonding strength even at room temperature. Therefore, the upper limit of the area percentage of the island-like Ag phase is preferably 35% or less. The area (particle size) of such individual island-like Ag phase is not particularly limited as long as it is a size discernible in a cross-section texture.

The area percentage of the Ag phase can be measured and calculated from an observation photograph/image obtained with observation of a cross-section texture with an appropriate tool. The cross-section texture is preferably observed as a longitudinal cross-section at any position of the bonding portion. The size of an observation region set in observation of the cross-section texture is not particularly limited, and such observation is preferably made so that an interface (upper and lower ends) between a nonbonding material and the bonding portion is included. The area percentage of the Ag phase can be calculated from the observation photograph/image, by use of appropriate image analysis software. For example, the area percentage can be calculated with observation of a cross section with SEM and also taking of an element mapping image with EDS, and reference to and analysis of an image where only an area high in Ag concentration is output.

The thickness of the bonding portion in the bonding structure of the present invention is preferably 10 µm or more and 200 µm or less, more preferably 20 µm or more and 150 µm or less, further preferably 20 µm or more and 100 µm or less.

### (4) Void ratio

Any void, when present in the bonding portion, not only serves as a medium propagating cracks, but also can by itself serve as a starting point of cracks. Therefore, the bonding structure of the invention is also preferably reduced in presence of such any void. Specifically, the void ratio in any cross section of the bonding portion is preferably 4% or less in terms of area ratio. In the invention, not only transient liquid phase diffusion bonding is applied, but also a compression-molded article of a Ag powder and a Sn powder is applied as the bonding material, as described below. Thus, a dense bonding portion with suppressed void generation can be formed. While the lower limit value of the void ratio is optimally 0%, the lower limit value is preferably 1% because such any void is actually difficult to completely eliminate.

### A-3. Diffusion layer (optional constitution) on bonding interface with materials to be bonded

The bonding structure of the invention has the above composition, and essentially has, as a main configuration, the bonding portion having the material texture configured from the island-like Ag phase and the AgsSn phase. Herein, an optional diffusion layer is allowed to be present on an interface between the materials to be bonded and the bonding portion. The diffusion layer is constituted from a constituent material of the materials to be bonded and a constituent material (in particular Sn) of the bonding portion. The bonding portion is formed with melting and diffusion of a low-melting point metal constituting the bonding material (insert metal), in transient liquid phase diffusion bonding. The low-melting point metal here often diffuses also toward the materials to be bonded. In the bonding structure of the invention, Sn being a low-melting point metal forms the AgsSn phase together with Ag, whereas some thereof can diffuse toward the materials to be bonded, to form a diffusion layer including a Sn alloy on a bonding interface.

The configuration of the diffusion layer on a bonding interface is determined based on a constituent material on surfaces of the materials to be bonded. In a semiconductor device, one material to be bonded is a circuit substrate including a Cu radiator plate, and other material to be bonded is a semiconductor element (Si or the like). In this case, an alloy of Cu and Sn is formed as a diffusion layer on a bonding interface (between the bonding portion and a Cu radiator plate) facing a circuit substrate in the bonding structure of the invention. Also in a semiconductor element, one or a plurality of metal films of Ni, Ti, and/or the like may be formed in such a semiconductor element in order that the bonding ability is ensured. In this case, one or a plurality of diffusion layers each including an alloy of such metals and Sn is/are formed on a bonding interface (between the bonding portion and such a metal film) facing such a semiconductor element, in the bonding structure of the invention.

The diffusion layer is not necessarily in the form of a continuous layer in a horizontal direction, and may be partially divided. The thickness is also not limited to that of a clear layer, and a Sn alloy in the form of a dot can also be referred to as "diffusion layer". Herein, the diffusion layer is an optional constituent component in the bonding structure of the invention, and is not an essential constituent component. The reason is because the diffusion layer less has an influence on properties themselves of the bonding portion.

### B. Method for producing bonding structure of the present invention

As described above, the bonding structure of the invention can be formed with transient liquid phase diffusion bonding. The transient liquid phase diffusion bonding means a method including placing the bonding material (insert metal) including the low-melting point metal and the high-melting point metal between the materials to be bonded, and heating them, as described above.

In the invention, a bonding portion mainly of Ag is formed with application of Sn as the low-melting point metal and application of Ag as the high-melting point metal. It is here important for formation of a bonding portion not only having the above material texture, but also suppressed in generation of any void and Sn phase, in order to increase the efficiencies of diffusion of Sn molten in the bonding material, toward Ag, and progression of formation of an alloy of diffused Sn and Ag. The inventors have made studies in view of this and thus have found application of a bonding material including a compression-molded article of a mixture of a Ag powder and a Sn powder, as the bonding material for formation of the bonding structure of the invention.

The bonding material including the compression-molded article is a solid bonding material obtained with pressurization and compression of a mixed powder of a Ag powder having an average particle size of 30 µm or more and 75 µm or less and a Sn powder having an average particle size of 1 µm or more and 20 µm or less, and then formation of the mixed powder into a sheet (foil) with rolling. Such a solid bonding material is applied for suppression of void generation in the bonding portion. The Ag powder and the Sn powder mixed are generally handled in the form of a paste where both are dispersed in a solvent. However, with such a paste, void generation due to volatilization of the solvent in bonding cannot be suppressed sufficiently. The solvent can also remain in the bonding portion and also causes void generation. In view of this, a solid bonding material which is solvent-free is applied.

The bonding material applied in the invention includes a compression-molded article obtained with pressurization and high-level compression/rolling of the mixture of the Ag powder and the Sn powder respectively having the average particle sizes. The Ag powder and the Sn powder respectively having the average particle sizes can be compressed/rolled at high levels to thereby allow diffusion of Sn molten and generation of an intermetallic compound to efficiently occur during transient liquid phase diffusion bonding.

The compression-molded article is a molded article having a relative density of 95% or more, preferably 98% or more, relative to a bulky metal (alloy) assumed based on the composition mixing ratio of each metal. The relative density can be calculated from the expression "Density of compression-molded article/Density of bulky metal (alloy)". The density of the compression-molded article and the density of the bulky metal (alloy) can be each determined from the volume and mass measured according to the Archimedes method or the like.

The mixing ratio between the Ag powder and the Sn powder in the compression-molded article serving as the bonding material is not needed to be the same as the composition of the bonding portion. The reason for this is because formation of the diffusion layer due to diffusion of Sn being the low-melting point metal in the bonding material, toward a bonding interface, should be counted. The amount of Sn in the bonding material for formation of the diffusion layer is varied depending on the mixing ratio between the Ag powder and the Sn powder, and transient liquid phase diffusion bonding conditions (temperature, pressure applied). Therefore, the mixing ratio in the bonding material is set in a relatively wide range, unlike a narrow composition range (Ag: 78.0% by mass or more and 80.0% by mass or less, Sn: 20.0% by mass or more and 22.0% by mass or less) in the bonding portion. Specifically, a compression-molded article having a mixing ratio where the Sn content is higher by 5% by mass or more and 20% by mass or less, as compared with the composition in the bonding portion, can be used as the bonding material.

The bonding portion of the invention can be formed with transient liquid phase diffusion bonding, with application of the bonding material including the compression-molded article of the Ag powder and the Sn powder. In such a bonding method, the bonding material is preferably placed between the pair of materials to be bonded and then heated at 200°C or more and 300°C or less. A bonding temperature of less than 200°C hardly allows Sn to be molten and thus hardly allows transient liquid phase diffusion bonding to progress, and cannot provide a bonding portion having a suitable composition. On the other hand, a too high bonding temperature easily causes Sn molten to be moved out of the bonding portion, and increases the variation in composition of the bonding portion due to lack of Sn around the Ag powder. Such lack of Sn also leads to a decrease in amount of Sn diffused toward the Ag powder, and also likely leads to an imbalance in amount between the island-like Ag phase and the AgsSn phase. Thus, a too high bonding temperature often provides no suitable configuration of the bonding portion. Furthermore, bonding at a high temperature may also cause a semiconductor element to be broken due to heat shock after bonding. Therefore, the upper limit of the bonding temperature is preferably 300°C. The heating time is preferably 1 minute or more and 1 hour or less, while depends on the thickness/volume of the bonding material including the compression-molded article. A nitrogen atmosphere is here recommended for prevention of oxidization of the bonding material, the substrate, and the like.

The bonding material is preferably heated under pressure in bonding portion formation with application of the bonding material. Such heating is aiming for promoting molten Sn to diffuse toward the Ag powder. The pressure applied to the bonding material is preferably 1 MPa or more. Such pressurization is preferably made through one of or both the materials to be bonded.

The bonding structure of the invention is formed through a bonding step with application of the bonding material including the compression-molded article of the Ag powder and the Sn powder, described above.

### ADVANTAGEOUS EFFECTS OF INVENTION

As described above, the bonding portion in the bonding structure of the present invention is configured from the Ag phase and the AgsSn phase, and the bonding portion is provided which is favorable in bonding strength and heat resistance by means of properties of each of the layers. The bonding portion is also excellent in durability, and can be well kept without any cracks caused due to repeated thermal stress. The bonding structure having the bonding portion of the invention can be formed with transient liquid phase diffusion bonding involving application of an appropriate bonding material.

### BRIEF DESCRIPTION OF THE DRAWINGS

[Fig. 1] A view schematically illustrating a material texture of the bonding portion in the bonding structure of the invention.
[Fig. 2] A photograph representing a material texture of a bonding portion in a bonding structure with respect to each sample produced in the present embodiment.
[Fig. 3] A mapping image with EDS, of a bonding portion in a bonding structure with respect to each sample produced in the embodiment.

### DETAILED DESCRIPTION OF THE PREFERRED EMBODIMENTS

Hereinafter, an embodiment of the invention is described with reference to Examples described below. In the embodiment, a compression-molded article was produced from a Ag powder and a Sn powder, and was adopted as a bonding material for bonding a semiconductor chip and a substrate, and a bonding portion was subjected to material texture observation and evaluation of properties such as heat resistance.

First, a Ag powder (purity 99.9% by mass, average particle size 54.6 µm) produced by an atomization method, and a Sn powder (purity 99.9% by mass, average particle size 3.7 µm) produced by an atomization method were mixed in a shaker, and thus a mixture was obtained. The average particle sizes of the Ag powder and the Sn powder were determined in observation of each of the powders with SEM (magnifications: 200x (Ag powder) and 2000x (Sn powder), image resolution: 1024 × 768, acceleration voltage: 15 kV). The average area of each of the powders was calculated from the areas and the number of such powders with a function attached to a SEM apparatus, and the equivalent circle diameter was defined as the average particle size. In the embodiment, the above powder having an average particle size of 54.6 µm and the above powder having an average particle size of 3.7 µm were respectively mainly used as the Ag powder and the Sn powder, and in some comparative examples, a Ag powder having an average particle size of 90 µm and a Sn powder having an average particle size of 24 µm were used. These powders were also each produced by an atomization method.

In the embodiment, the mixing ratio between the Ag powder and the Sn powder was changed, and each mixture where the Sn content was 20% by mass, 25% by mass, 27% by mass, 30% by mass, 35% by mass, 40% by mass, 45% by mass, or 50% by mass was produced. Such each mixture of the Ag powder and the Sn powder was poured into a cylindrical mold, and compressed in a hydraulic pressing machine, and thus a flat disc-shaped molded article was obtained. The pressure in pressing was 5 ton. The compressed article completed was rolled on a desk roller, and thus a sheet-shaped compression-molded article having a thickness of 0.1 mm was obtained and adopted as a bonding material. The relative density of a Ag/Sn alloy (bulky metal) having the same composition as the mixing ratio in the bonding material produced in the embodiment was measured by the Archimedes method, and was confirmed to fall within the range from 95% to 100% even if the measurement error was counted.

Next, a plurality of bonding materials produced as above were used for bonding of a semiconductor chip and a circuit substrate, and thus a bonding structure was formed. A semiconductor chip was a Si chip, and bonded to a Cu substrate (KFC material) as a circuit substrate.

In the embodiment, a Si chip (2 mm × 2 mm) having one surface metalized with Ti (0.01 µm)/Ni (0.3 µm)/Ag (0.2 µm) was prepared for production of a sample for a bonding strength evaluation test (die shear test) described below. Four of the Si chips were placed on a carbon jig so that surfaces metalized faced upward. Next, one of the bonding material (10 mm × 10 mm) produced as above was placed on the four Si chips, and then a Cu substrate (11 mm × 11 mm, thickness 0.2 mm) was placed on the bonding material. A carbon jig was placed thereon, and the Si chip/bonding material/Cu substrate was sandwiched and thereafter secured with a jig equipped with a spring (pressure applied: 2 MPa).

A Si chip (10 mm × 10 mm) having the same configuration as described above was prepared for production of each sample for cross section observation and a heat cycle test of a bonding portion described below. One of the Si chip was placed in the same procedure as described above, one bonding material (10 mm × 10 mm) was placed thereon, furthermore a Cu substrate (11 mm × 11 mm, thickness 0.2 mm) was placed thereon, and the resultant was secured with a carbon jig (pressure applied: 2 MPa).

A sample of the Si chip/bonding material/Cu substrate secured as described above was introduced together with the jig into a low-oxygen oven (IPHH-202MS manufactured by Espec Corp.), and heated, and thus a bonding portion was formed. Such a heating treatment was performed with the start of temperature rise after the oven was purged with nitrogen for 30 minutes and the oxygen concentration reached 70 ppm or less. The heating was performed at a rate of temperature rise of 5°C/min under nitrogen flow until the temperature reached a bonding temperature set. Once the temperature in the oven reached the bonding temperature, the resultant was heated and retained at the bonding temperature under nitrogen flow for 30 minutes. After a lapse of 30 minutes, a blower of the oven was turned on and the temperature was dropped under nitrogen flow for 30 minutes (rate of temperature drop: about -5°C/min). Once the temperature in the oven reached 40°C, the sample was taken out and the jig was removed. In the embodiment, the bonding temperature was set to 250°C with respect to each of the above eight bonding materials. Such bonding temperatures were set to 185°C, 225°C, 250°C, 275°C, and 315°C with respect to some of the bonding materials (Sn content 27% by mass), and thus each bonding portion was formed.

### [Material texture observation and composition analysis of bonding portion]

After the bonding step and observation of a material texture of a cross section of the bonding portion, the composition (composition analysis of an island-like Ag phase and a AgsSn phase, the area percentage of the island-like Ag phase, and the void ratio in the cross section of the bonding portion were measured.

In such observation and measurement, the sample (Si chip/bonding material/Cu substrate) subjected to bonding structure production described above was embedded into a resin, and around the center thereof was cut, and a cross section was polished. The cross section of the sample was observed with a scanning electron microscope (SEM: JSM-IT500HR manufactured by JEOL Ltd.), and a photograph of the cross section was taken. The magnification in SEM observation was adjusted to one, which enabled even upper and lower ends of the bonding portion to be observed, and observation in the embodiment was made with the acceleration voltage being set to 15 kV and the magnification being set to 1000x in SEM. In such observation and measurement, the entire bonding portion (but including no bonding interface) was an observation region.

EDS analysis (acceleration voltage 15 kV) was performed with an energy dispersive X-ray analyzer (EDS) attached to a SEM apparatus, for composition analysis of the bonding portion. First, each phase estimated to be the island-like Ag phase and the AgsSn phase with SEM observation was subjected to spot analysis at three points for a number of times of sampling (measurement time 30 seconds) of 10000 per point. As a result, it was confirmed that the composition of the island-like Ag phase was 100% by mass of Ag and the composition of the AgsSn phase was 73% by mass of Ag-27% by mass of Sn.

Next, mapping with EDS was performed and the area percentage of the island-like Ag phase was measured. An observation region (magnification: 10000x) of the cross section of the bonding portion was first subjected to element mapping. In the embodiment, the mapping resolution was 256 × 192 pixels, and the analysis elements were Ag, Sn, Cu, Si, and Ni. In such mapping analysis with EDS, sampling (counting) at each pixel was preferably sufficiently performed for precise analysis of the composition at each pixel as much as possible. A suitable index exemplified was to perform sampling 2000 times or more per pixel, and in the embodiment, such each element for analysis was subjected to measurement for a number of times of sampling of 2500 per pixel.

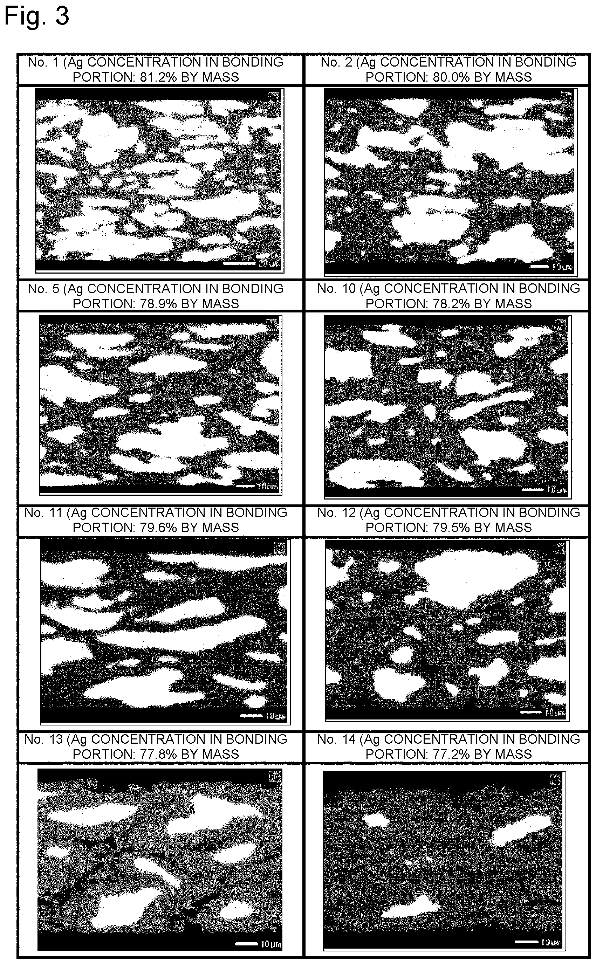

It was confirmed from the results of mapping analysis of each of the samples that a region having a Ag concentration of about 100% by mass and a region having a Ag concentration of about 73% by mass were present in the cross section of the bonding portion. The resulting mapping image was binarized with a predetermined Ag concentration as a threshold, and a mapping image (Ag mapping image) for distinction between the Ag phase and the AgsSn phase was created. The Ag concentration serving as a threshold was a Ag concentration of 85% by mass set in the embodiment, and a region having a concentration equal to or more than the threshold was defined as the Ag phase and a region having a concentration equal to or less than the threshold was defined as the AgsSn phase for creation of a Ag mapping image. Such a Ag mapping image created was used and image analysis software (trade name: MIPAR) was applied for calculation of the area percentage of the Ag phase. Fig. 3 illustrates a mapping image of each of the samples, prepared based on the Ag concentration. A light color portion corresponds to the island-like Ag phase and a dark color portion corresponds to the AgsSn phase in such each image.

The void ratio was determined with measurement of the area percentage in the SEM image taken in the SEM observation, by means of the same image analysis software as described above. In the image analysis, a portion clearly determined to correspond to a void in the SEM image (a portion of a color close to black in the image) was adopted as reference, and the area percentage of a portion in the same color tone as such a void portion was measured.

### [Evaluation (die shear test) of bonding strength]

Next, the bonding strength of the bonding portion of each of the samples was measured. A bonding strength evaluation test (die shear test) was performed with a test at room temperature and a test in the state of heating at 260°C, of each of the samples produced as described above. In bonding strength measurement, such each sample was installed in a bond tester (MFM1200L manufactured by TRY Precision Technology Co., Ltd.) as a measurement apparatus so that the Cu substrate faced downward, a tool (click) of the tester was hung to an end of the chip, and the die shear strength was measured under application of a shear load of 200 kg. A case where the shear strength was 20 MPa or more was rated as "pass (o)", and a case of pass in both the tests at room temperature and a high temperature was rated as "suitable bonding portion".

### [Evaluation of heat cycle durability]

Furthermore, a heat cycle test of the bonding portion of each of the samples was performed for confirmation of durability in heating/cooling cycles. In the heat cycle test, a heat cycle was defined as one cycle of retention at -50°C for 30 minutes/retention at 175°C for 30 minutes and each of the samples was subjected to 250 cycles. The bonding portion after 250 cycles was confirmed with respect to peeling and the presence of cracks. Herein, no heat cycle test was performed in any sample having a bonding strength of the lower limit value or less (5 MPa or less) at room temperature or a high temperature in the die shear test.

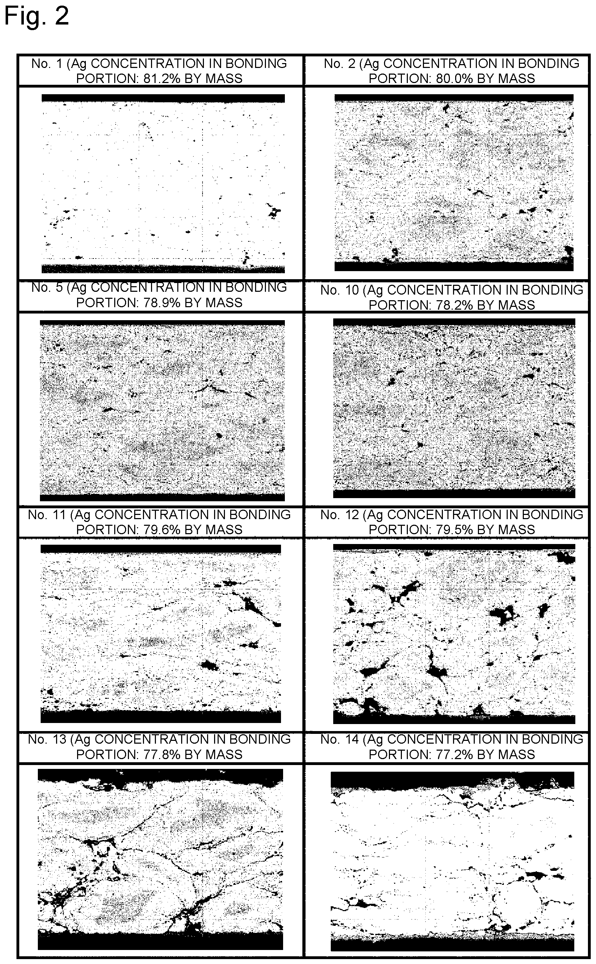

The above test results are shown in Table 1. Table 1 also shows the composition of the bonding portion and the area percentage of the island-like Ag phase, of each of the samples, and furthermore the measurement results of the void ratio. Each SEM photograph of bonding portions (bonding temperature 250°C) of Nos. 1, 2, 5, 10, 11, 12, 13, and 14 in Table 1, as an observation image example of the material texture of the bonding portion of each of the samples, is illustrated in Fig. 2, and each mapping image thereof is illustrated in Fig. 3.

**[Table 1]**

| No. | Composition (% by mass) of bonding material | | | | Bonding temperature (°C) | Bonding portion configuration | | | | | Bonding strength evaluation | | | | Pass/ Fail in heat cycle test | |
|---|---|---|---|---|---|---|---|---|---|---|---|---|---|---|---|---|
| | | | | | | Composition (% by mass) | | Island-like Ag phase | | Void ratio | Room temperature | | Heating at 260°C | | | |
| | Ag powder | | Sn powder | | | Ag content | Sn content | Ag content (% by mass) | Area percentage | | Shear strength [MPa] | Pass/ Fail | Shear strength [MPa] | Pass/ Fail | | |
| | Particle size (µm) | Mixing ratio | Particle size (µm) | Mixing ratio | | | | | | | | | | | | |
| 1 | 54.6 | 80% | 3.7 | 20% | 250 | 81.2% | 18.8% | 100% | 35.4% | 4% | 17 | Fail | 8 | Fail | Fail | Comparative Example |
| 2 | | 75% | | 25% | | 80.0% | 20.0% | 100% | 33.6% | 3% | 25 | Pass | 45 | Pass | Pass | Example |
| 3 | | 73% | | 27% | 185 | 68.3% | 31.7% | 100% | 36.0% | 1% | 5 or less | Fail | 5 or less | Fail | - | Comparative Example |
| 4 | | | | | 225 | 78.1% | 21.9% | 100% | 20.3% | 4% | 52 | Pass | 35 | Pass | Pass | Example |
| 5 | | | | | 250 | 78.9% | 21.1% | 100% | 29.6% | 2% | 76 | Pass | 52 | Pass | Pass | Example |
| 6 | | | | | 275 | 79.8% | 20.2% | 100% | 24.2% | 4% | 50 | Pass | 36 | Pass | Pass | Example |
| 7 | | | | | 315 | 81.2% | 18.8% | 100% | 41.2% | 3% | 38 | Pass | 19 | Fail | Fail | Comparative Example |
| 8 | 90.0 | | | | 250 | 84.1% | 15.9% | 100% | 40.3% | 3% | 32 | Pass | 11 | Fail | Fail | Comparative Example |
| 9 | 54.6 | | 24.0 | | | 85.0% | 15.0% | 100% | 39.2% | 3% | 31 | Pass | 12 | Fail | Fail | Comparative Example |
| 10 | | 70% | 3.7 | 30% | | 78.2% | 21.8% | 100% | 25.8% | 2% | 55 | Pass | 31 | Pass | Pass | Example |
| 11 | | 65% | | 35% | | 79.6% | 20.4% | 100% | 30.3% | 3% | 45 | Pass | 35 | Pass | Pass | Example |
| 12 | | 60% | | 40% | | 79.5% | 20.5% | 100% | 26.1% | 4% | 38 | Pass | 21 | Pass | Pass | Example |
| 13 | | 55% | | 45% | | 77.8% | 22.2% | 100% | 17.0% | 7% | 34 | Pass | 5 or less | Fail | - | Comparative Example |
| 14 | | 50% | | 50% | | 77.2% | 22.8% | 100% | 5.2% | 4% | 22 | Pass | 12 | Fail | Fail | Comparative Example |

It was found with reference to Table 1, and Fig. 2 and Fig. 3 that the bonding portion having the material texture configured from the Ag phase and the AgsSn phase was formed with transient liquid phase diffusion bonding with the compression-molded article of the Ag powder and the Sn powder, produced in the embodiment, as a bonding material. However, the sample lack in bonding strength or inferior in heat cycle durability was formed depending on the composition of the bonding portion. Specifically, the bonding portion, when had a Ag content of less than 78.0% by mass (No. 3, 13, and 14), was inferior in bonding strength at a high temperature. The bonding portion, when had a Ag content of more than 80.0% by mass (No. 1, Nos. 7 to 9), failed in terms of bonding strength at a high temperature, although was likely higher in bonding strength than a sample having a Ag content of less than 78.0% by mass. Such a bonding portion, when did not fall within such a suitable composition range, was peeled/cracked also in the heat cycle test. Accordingly, it is considered that the bonding portion in the bonding structure of the invention, with transient liquid phase diffusion bonding, ensures bonding strength and durability due to optimization of not only the material texture of the Ag phase and the AgsSn phase, but also the composition range.

It is preferable from the viewpoint of optimization of the material texture to allow the area percentage of the island-like Ag phase to be suitable. The area percentage of the island-like Ag phase is not highly varied with respect to any bonding portion (No. 2, No. 4 to No. 6, and Nos. 10 to 12) having a suitable composition. Such any bonding portion has suitable bonding strength and heat cycle durability. On the other hand, when the composition of the bonding portion does not fall within the scope of the invention, the area percentage of the island-like Ag phase is likely to be less than 18% or more than 35%. In particular, a bonding portion of No. 13, although had a composition of the bonding portion, extremely close to the present range, was slightly lack in bonding strength. Such lack was considered to be due to lack of the island-like Ag phase.

While the bonding portion was formed with the compression-molded article of the Ag powder and the Sn powder, as a bonding material, in the embodiment, the configuration and bonding conditions (bonding temperature) of the bonding material also had an influence on the composition of the bonding portion. A bonding material with a coarse Ag powder or Sn powder was applied in each bonding portion in Nos. 8 and 9, and such each bonding portion had a high Ag content and was also high in area percentage of the island-like Ag phase, as compared with the bonding portion with application of the bonding material having the same mixing ratio. No. 3 (bonding temperature 185°C) and No. 7 (bonding temperature 315°C), in which the bonding temperature was out of a condition of 200°C or more and 300°C or less, respectively had a low Ag content and a high Ag content. It is presumed that the bonding temperature has an influence on diffusion of Sn molten, in bonding. Herein, the bonding portions formed in the embodiment, except for that of No. 13, each had a low void ratio of 4% or less. This is considered to be due to the effect with transient liquid phase diffusion bonding of a solid bonding material (the compression-molded article of the Ag powder and the Sn powder) unlike a conventional paste.

### INDUSTRIAL APPLICABILITY

The bonding structure of the invention includes a bonding portion having a specific material texture configured from a Ag phase and a AgsSn phase. The bonding portion is favorable in bonding strength and excellent in heat resistance/durability due to heat resistance of the Ag phase and the AgsSn phase and softness of the Ag phase. The invention can be suitably applied in bonding or the like of a device element in a semiconductor device such as a power device such as a hybrid car or an EV.

## Claims

1. A bonding structure comprising: a pair of materials to be bonded; and a bonding portion formed between the pair of materials to be bonded, wherein
the bonding portion comprises, as constituent elements, 78.0% by mass or more and 80.0% by mass or less of Ag, 20.0% by mass or more and 22.0% by mass or less of Sn, and an inevitable impurity element, and
a material texture configured from an island-like Ag phase comprising 95% by mass or more of Ag and a AgsSn phase comprising a AgsSn intermetallic compound and surrounding the island-like Ag phase is observed in observation of any cross section of the bonding portion.

2. The bonding structure according to claim 1, wherein an area percentage of the island-like Ag phase in any cross section of the bonding portion is 18% or more and 35% or less.

3. The bonding structure according to claim 1 or claim 2, wherein a void ratio in any cross section of the bonding portion, in terms of area percentage, is 4% or less.

4. A semiconductor device comprising a semiconductor element and a substrate bonded to each other, wherein
the semiconductor device comprises the bonding structure defined in any one of claim 1 to claim 3, between the semiconductor element and the substrate.

5. A bonding material for transient liquid phase diffusion bonding, for use in bonding of a pair of materials to be bonded, with transient liquid phase diffusion bonding, wherein
the bonding material comprises a sheet-shaped compression-molded article obtained by compression and rolling of a mixed powder of a Ag powder having an average particle size of 30 µm or more and 75 µm or less and a Sn powder having an average particle size of 1 µm or more and 20 µm or less, and
the compression-molded article has a relative density of 95% or more based on a density of a bulky metal having the same composition as the mixing ratio in the mixed powder.
